(19) Europäisches Patentamt
European Patent Office
Office européen des brevets

(11) **EP 4 029 968 B1**

(12) **EUROPEAN PATENT SPECIFICATION**

(45) Date of publication and mention
of the grant of the patent:
**04.06.2025 Bulletin 2025/23**

(21) Application number: **20869963.7**

(22) Date of filing: **25.09.2020**

(51) International Patent Classification (IPC):
*C23C 14/24* (2006.01)     *C23C 14/16* (2006.01)
*C23C 14/26* (2006.01)     *C23C 14/56* (2006.01)

(52) Cooperative Patent Classification (CPC):
**C23C 14/16; C23C 14/243; C23C 14/26;
C23C 14/562**

(86) International application number:
**PCT/CN2020/117882**

(87) International publication number:
**WO 2021/057921 (01.04.2021 Gazette 2021/13)**

(54) **VACUUM COATING DEVICE**

VAKUUMBESCHICHTUNGSANLAGE

DISPOSITIF DE REVÊTEMENT SOUS VIDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.09.2019 CN 201910915434**

(43) Date of publication of application:
**20.07.2022 Bulletin 2022/29**

(73) Proprietor: **BAOSHAN IRON & STEEL CO., LTD.
Shanghai 201900 (CN)**

(72) Inventors:
• **REN, Sanbing**
**Shanghai 201900 (CN)**
• **FAN, Junfei**
**Shanghai 201900 (CN)**
• **LI, Shanqing**
**Shanghai 201900 (CN)**
• **XIONG, Fei**
**Shanghai 201900 (CN)**
• **WANG, Yiru**
**Shanghai 201900 (CN)**

(74) Representative: **Maiwald GmbH
Elisenhof
Elisenstraße 3
80335 München (DE)**

(56) References cited:
WO-A1-2014/168352    CN-A- 101 855 380
CN-A- 109 321 878    CN-A- 109 487 216
CN-U- 206 289 295    CN-U- 207 537 525
JP-A- 2015 010 257    KR-A- 20140 071 821
US-A1- 2005 034 669

Remarks:
The file contains technical information submitted after the application was filed and not included in this specification

**Description**

TECHNICAL FIELD

The present invention relates to a vacuum coating device for coating a steel plate.

BACKGROUND

Physical vapor deposition (PVD) refers to a process technology of heating the metal to be coated under vacuum to deposit the metal in a gaseous manner on a base material to form a coating. PVD can be classified into electric heating PVD (resistance type or induction type), electron beam heating PVD (EBPVD) and other ways by heating methods. As a surface modification and coating process, vacuum coating has been widely used in electronics, glass, plastics, and other industries. The main advantages of the vacuum coating technology include environmental protection, good coating performance, and diversity of coating materials. The key to apply the vacuum coating technology to continuous strip steel includes several aspects such as continuous, large area, high speed, and large scale of coating production. Since the 1980s, the world's major iron and steel companies have conducted lots of research on this technology. With the maturity of hot-dip galvanizing and electro-galvanizing technologies, this technology has attracted unprecedented attention and is considered as an innovative surface coating process.

The key issue in the vacuum coating process is how to obtain a uniform coating with a consistent thickness through the arrangement of nozzles. At present, foreign published information mainly includes the following aspects.

1) Integrated structure of the evaporation crucible and the flow distribution nozzle

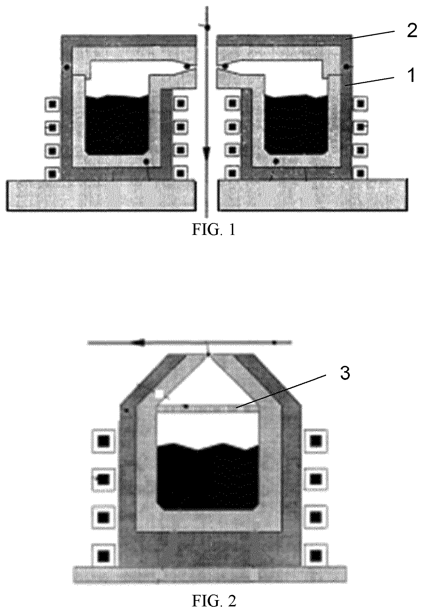

Applications BE1009321A6 and BE1009317A61 respectively disclose the crucible nozzle structures as shown in FIG. 1 and FIG. 2. In the structure of FIG. 1, an upper cover 2 is arranged on an upper part of a crucible 1, so that a nozzle structure is formed between the upper cover 2 and a furnace wall for the direct spray of evaporated metal. In the structure of FIG. 2, a filter plate 3 is additionally arranged in an evaporation crucible, and then metal steam is sprayed from a slit nozzle at the top. In the nozzle design processes of the two devices, one adopts a de Laval nozzle, and the other adopts a convergent nozzle. Regarding the orientation of the nozzles, one adopts the lateral spray, and the other adopts the vertical spray.

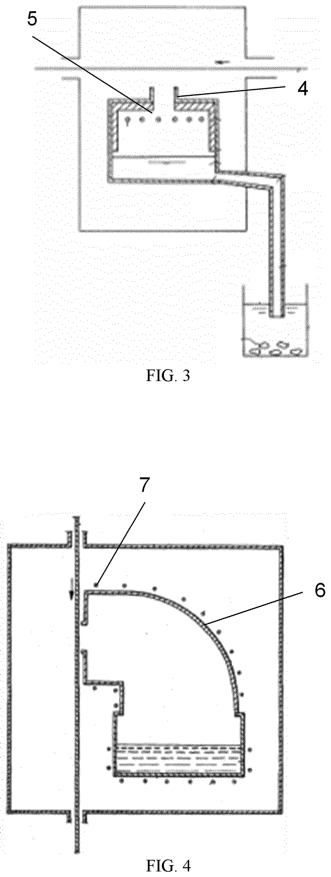

Applications JPS59177370A and US4552092A also disclose related evaporation crucible and nozzle structure. FIG. 3 illustrates a crucible nozzle structure with automatic replenishment of molten metal. A nozzle 4 uses a wide outlet, and a heater 5 is also arranged at an upper part of the crucible for heating the crucible. In the crucible nozzle structure shown in FIG. 4, the structure is spread by an arc 6 on one side, realizing lateral spraying; and a heating tube 7 is also arranged on the periphery of a crucible wall for heating the periphery surface.

2) Split structure of the evaporation crucible and the flow distribution nozzle

Application WO2018/020311A1 discloses a split crucible nozzle structure. As shown in FIG. 5, in the device, the bottom of the crucible is connected to a molten metal supply tank 8, and the upper part of the supply tank 8 conveys metal steam to a tubular distributor and a steam nozzle at the front end through a split pipe 9; and then, the nozzle sprays the metal steam to a metal plate at a high speed.

Application CN103249860A discloses a split structure of a flow distributor and a nozzle. As shown in FIG. 6, steam is delivered into an upper horizontal pipe 10 through a vertical pipe. The horizontal pipe 10 is provided with a multi-hole nozzle at the top to uniformly spray metal steam onto a surface of a metal plate.

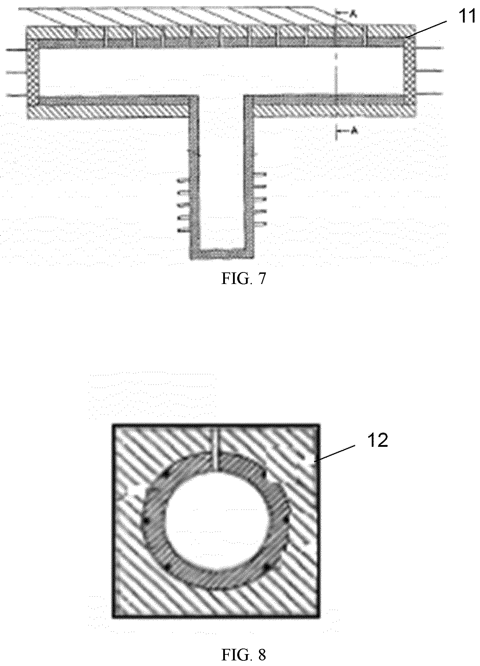

Application CN101175866A discloses a metal steam flow distributor and a nozzle form. For a sectional form of a nozzle as shown in FIG. 7, a wire is wound outside a flow distributor pipe 11 to heat the pipe; and the nozzle has a square shell. As shown in FIG. 8, a ringlike pipe made from another material is nested inside a square shell 12 and is used for spraying the metal steam. The steam outlet of the nozzle is multi-hole.

WO 2014/168352 A1 relates to an evaporation deposition apparatus and an operating method thereof. The evaporation deposition apparatus comprises: a first cavity for receiving an evaporation material; a second cavity for receiving steam through the first cavity and a connection channel; an evaporator formed in the second cavity, including an outlet for radially discharging the steam having a point source, and formed of a conductive material; a reflective nozzle formed of a conductive material, connected to the outlet, and including a through-hole having a gradually-increased diameter; an inductive coil for covering the reflective nozzle and the evaporator; and an alternating current power source for applying alternating current electric power to the inductive coil. The inductive coil inductively heats the evaporator and the reflective nozzle to evaporate the evaporation material, and the steam is discharged through the reflective nozzle.

The above-mentioned applications all relate to the specific forms of nozzles. However, not all of these nozzles can achieve sufficient uniform coatings with consistent thickness. Moreover, those researches do not focus on the yield of the coating.

SUMMARY

In order to solve the above-mentioned defects in the prior art, the present invention aims to provide a vacuum coating device, which can form uniform coatings with consistent thickness and improve the yield of the coating. The yield of coating refers to the ratio of the width of the effective coating to the width of the strip steel, the effective coating can be understood as a coating with a thickness of 1~20$\mu$m. The thickness deviation ($d_{max}$-$d_{min}$) is less than or equal to 25%.

In order to achieve the foregoing objective, the present invention provides the following technical solutions.

A vacuum coating device for coating a steel plate, comprising: a crucible (13), an induction heater (15) provided on the periphery of the crucible (13), a flow distribution box (17) connected to the top of said crucible (13) via a steam pipe (16), wherein said steam pipe (16) is provided with a pressure regulating valve (18), said flow distribution box (17) is provided inside with a horizontal pressure stabilizing plate (19), said flow distribution box (17) is connected on the top with a nozzle (20), a deflector (21) being arranged above said nozzle (20) along the emitting direction of the steam and wherein
a distance Da from nozzle outlet to steel plate (100) is 10~200 mm, a height Db of said deflector (21) is 10~199 mm; a distance Dc from top of said deflector (21) to steel plate (100) is 1~190 mm; an angle Dd between said deflector (21) and said nozzle outlet is 60°~135°; wherein Da, Db, Dc, and Dd satisfy the following relationships: Da=Db+Dc;

when Da=100~200mm and Db=(1/5~1/2)Da, Dd=60°~90°;
when Da=100~200mm and Db=(1/2~2/3)Da, Dd=70°~110°;
when Da=100~200mm and Db=(2/3~4/5)Da, Dd=80°~135°;
when Da=10~100mm and Db=(1/5~1/2)Da, Dd=60°~100°;
when Da=10~100mm and Db=(1/2~2/3)Da, Dd=70°~120°;
when Da=10~100mm and Db=(2/3~4/5)Da, Dd=80°~135°.

In the prior art, steam is emitted from the nozzle and spreads out, thus the amount of steam at the edge of the steel plate is relatively low, leading to a non-uniform coating formed by metal vapor on the middle area and edge area of the steel plate. Then additional processes are required to cut off the unevenly coated part of the steel plate. The cutting ratio usually reaches 15~20%, which not only leads to poor yield of coating, but also increases the production cost. The technical solution adopted in the present invention restricts the path of steam from the nozzle to the steel plate by the arrangement of the deflector, which prevents the metal steam from spreading out and concentrates the steam in the area where the steel plate passes, thus a uniform coating can be obtained.

The distance Da from said nozzle outlet to said steel plate is 10~200mm. Based on actual installation distance from the nozzle outlet to the steel plate, Da is usually greater than or equal to 10mm. When Da≥200mm, the injection angle of the steam increases, the injection range is large, and the coating thickness decreases, resulting in that the coating cannot have an effect of anti-erosion. Moreover, when Da≥200mm, the speed of steam ejecting to the steel plate decreases, leading to the poor adhesion and low density of the coating.

The height Db of said deflector is 10~199mm. That height is determined by the distance between the nozzle outlet and the steel plate. When the nozzle outlet is very close to the steel plate, the height of the deflector reaches lower limit, which is 10mm; when the nozzle outlet is far from the steel plate, the height of the deflector reaches upper limit, which is 199mm. In the technical solution of the present invention, Da is usually greater than or equal to Db. That is, when the width of steel plate is less than the effective width of nozzle outlet, the deflector is flush with the edge of the steel plate in height.

The distance Dc from the top of said deflector to steel plate is 1~190mm. For example, when Db=199mm, Dc=1mm; when Db=10mm, Dc can be10mm.

When the pressure inside the nozzle is 500~100,000Pa, and the pressure of the external ambient where the nozzle is located is $10^{-4}$~10 Pa, the angle Dd between said deflector and said nozzle outlet is 60°~135°. When the width of steel plate is less than the width of nozzle outlet or the effective width of the steel plate needs to be coated is less than the width of nozzle outlet, Dd can be less than 90° according to production needs. For example, Dd can be 60°, and then a uniform coating can be obtained. When the width of steel plate is greater than the width of nozzle outlet, a large Dd can be adopted according to production needs. For example, a Dd of 135° can be adopted to improve the uniformity of the coating thickness at the edge of the steel plate. However, when Dd is greater than 135°, the speed and range of the jet at the edge of the steel plate cannot be satisfied.

Said pressure stabilizing plate is a pressure stabilizing plate made of multi-hole media. That type of pressure stabilizing plate filters gas through irregular holes that resemble honeycombs. And according to the production needs, different porosity can be used to change the steam distribution, so as to have uniform steam.

Or, said pressure stabilizing plate is of a multi-hole structure. The holes in said pressure stabilizing plate are rectangular, circle or triangular in shape. Or, the shape of holes can be arbitrary polygonal or circle. And those holes run in linear, curvilinear or have a multilayer structure in the direction of steam rise. Since the pressure stabilizing plate has a certain thickness, the distribution direction of holes refers to the path of steam through the thickness direction of the pressure stabilizing plate. That is, when steam passes through the pressure stabilizing plate, not only the distribution of steam can be changed by the distribution of holes in the pressure stabilizing plate, but also the path of its rise can be changed by the direction of holes. The multilayer structure refers to a structure in which the distribution direction of holes directs the steam to rise in steps. For example, the multilayer structure can be steps formed by multiple sets of folds, which can increase the resistance of steam rise, but allow for more evenly distributed steam.

Said nozzle outlet is of a slit shape or a multi-hole. Preferably, the nozzle outlet is of a slit shape.

The nozzle outlet is of a linear slit or a curvilinear slit. The slit shape refers to that the nozzle outlet is a whole slit rather than made up of multiple tiny slits set at intervals. That is because if the steam is emitted from each tiny slit, it will spread out to a certain extent, and the overlap area makes the coating thickness larger and does not form a uniform coating.

The multi-hole nozzle outlet is rectangular, round or trapezoidal in shape.

Said nozzle is made of graphite, ceramic or metal.

Da, Db, Dc, and Dd satisfy the following relationships:

$$Da=Db+Dc;$$

when $Da=100\sim200mm$ and $Db=(1/5\sim1/2)Da$, $Dd=60°\sim90°$;
when $Da=100\sim200mm$ and $Db=(1/2\sim2/3)Da$, $Dd=70°\sim110°$;
when $Da=100\sim200mm$ and $Db=(2/3\sim4/5)Da$, $Dd=80°\sim135°$;
when $Da=10\sim100mm$ and $Db=(1/5\sim1/2)Da$, $Dd=60°\sim100°$;
when $Da=10\sim100mm$ and $Db=(1/2\sim2/3)Da$, $Dd=70°\sim120°$;
when $Da=10\sim100mm$ and $Db=(2/3\sim4/5)Da$, $Dd=80°\sim135°$.

If the above relationships are satisfied, the yield can reach more than 90%; and if the above relationships are not satisfied, the yield cannot reach 90%.

The vacuum coating device further comprises a vacuum chamber, wherein both said flow distribution box and said steel plate are placed in said vacuum chamber. By adopting this technical solution, on the one hand, it can prevent the oxidation of the nozzle material and steel plate coating. On the other hand, it can cause an internal and external pressure difference in the nozzle, so that the steam emitted from the nozzle outlet can reach supersonic speed.

The present invention discloses a vacuum coating device for improving the yield of vacuum coating, where the metal steam is obtained by melting and evaporating the metal material in the crucible. The steam enters the flow distribution box through the pipe, the flow distribution box is arranged with a pressure stabilizing plate and other relative devices, and then the uniform steams can flow from the nozzle. Since a deflector is arranged at the top of said nozzle, even steam distribution can be given between the deflector and the steel strip to be coated. The deflection of the steam field at the edge of the steel strip can be adjusted by changing the distance between the deflector and the steel strip, thus improving the yield of the coating on the steel strip. The present invention is low cost, simple to operate, and can be exported in sets with vacuum coating technology in the future.

BRIEF DESCRIPTION OF THE DRAWINGS

FIG. 1 is a schematic diagram of application BE1009321A6;
FIG. 2 is a schematic diagram of application BE1009317A61;
FIG. 3 is a schematic diagram of application JPS59177370A;
FIG. 4 is a schematic diagram of application US4552092A;

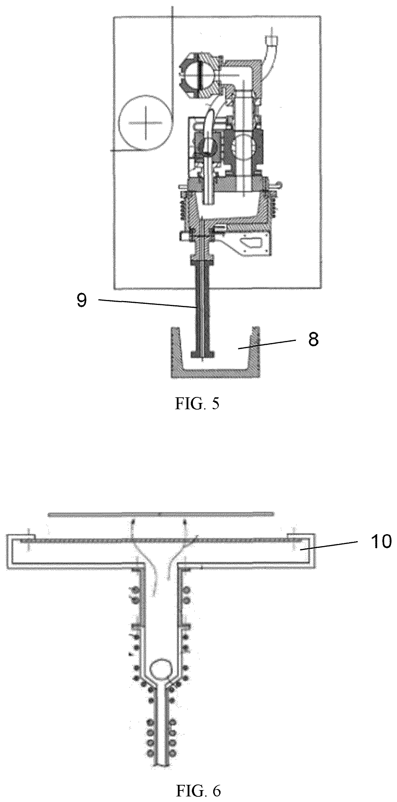

FIG. 5 is a schematic diagram of application WO2018/020311A1;
FIG. 6 is a schematic diagram of application CN103249860A;
FIG. 7 is a schematic diagram of application CN101175866A;
FIG. 8 is a schematic diagram of the square shell in FIG. 7;
FIG. 9 is a schematic diagram of the structure of the vacuum coating device of the present invention;
FIG. 10 is a side view of the vacuum coating device of FIG. 9; and

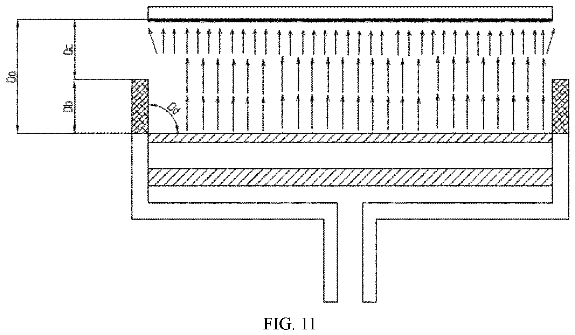

FIG. 11 is an enlarged view of the flow distribution box, the deflector and the steel plate in the vacuum coating device of FIG. 9.

DETAILED DESCRIPTION OF THE EMBODIMENTS

The technical solutions of the present invention are further described below with reference to the accompanying drawings and embodiments.

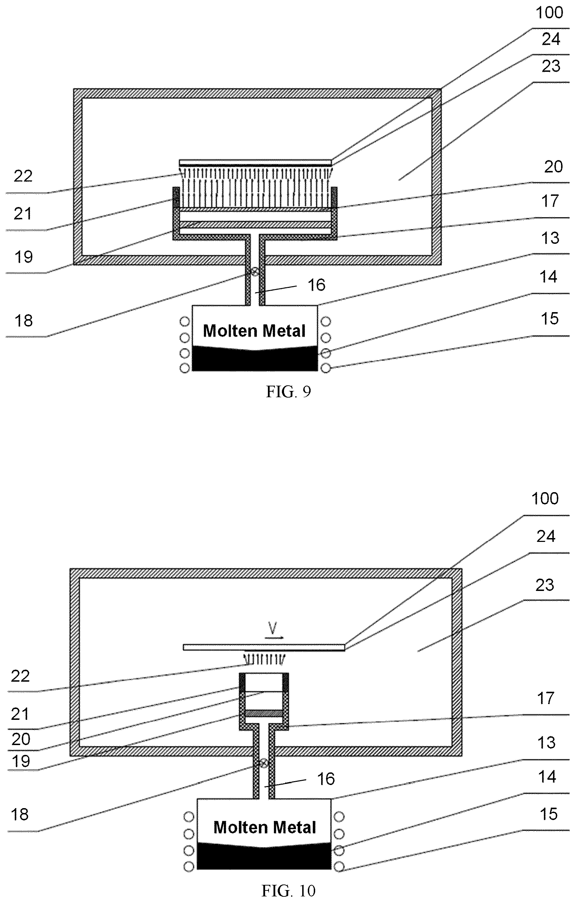

Referring to FIG. 9 and FIG. 10, the present invention provides a vacuum coating device. Said vacuum coating device is located underneath the steel plate 100 when in use. The vacuum coating device comprises a crucible 13, and the crucible 13 contains the molten metal 14. An induction heater 15 is arranged on the periphery of the crucible 13, the molten metal 14 and metal steam 22 can be obtained after the metal materials in crucible 13 are heated by the induction heater 15. The power of the induction heater 15 is adjustable, thus the pressure of the metal steam 22 in crucible 13 can be controlled. A flow distribution box 17 is connected to the

**EP 4 029 968 B1**

top of said crucible 13 via a steam pipe 16, wherein said flow distribution box 17 and said steel plate 100 are placed in the vacuum chamber 23. A pressure regulating valve 18 is arranged in said steam pipe 16, the exchange between the steam in crucible 13 and the steam in the flow distribution box 17 and the vacuum chamber 23 can be blocked by the pressure regulating valve 18. A horizontal pressure stabilizing plate 19 is arranged in said flow distribution box 17, and a nozzle 20 is connected to the top of said flow distribution box 17. In addition, a deflector 21 is arranged at the top of said nozzle 20 along the direction of steam emission to increase the yield. When said pressure regulating valve 18 on said steam pipe 16 is open, said metal steam 22 reaches said steel plate 100 through said pressure stabilizing plate 19 and said nozzle 20, and then a coating is formed.

Preferably, said deflector 21 serves to make the steam through said nozzle outlet as vertical as possible towards said steel plate 100, avoiding flow deflection and thus increasing the yield of coating on the steel plate 100.

Wherein, the distance Da from the outlet of said nozzle 20 to said steel plate 100 is 10~200mm; the height Db of said deflector 21 is 10~199mm; the distance Dc from the top of said deflector 21 to said steel plate 100 is 1~190mm; the angle Dd between said deflector 21 and the outlet of said nozzle 20 is 60°~135°.

Further, Da, Db, Dc, and Dd satisfy the following relationships:

$$Da=Db+Dc;$$

when Da=100~200mm and Db=(1/5~1/2)Da, Dd=60°~90°;
when Da=100~200mm and Db=(1/2~2/3)Da, Dd=70°~110°;
when Da=100~200mm and Db=(2/3~4/5)Da, Dd=80°~135°;
when Da=10~100mm and Db=(1/5~1/2)Da, Dd=60°~100°;
when Da=10~100mm and Db=(1/2~2/3)Da, Dd=70°~120°;
when Da=10~100mm and Db=(2/3~4/5)Da, Dd=80°~135°.

Preferably, said nozzle 20 operates with an internal pressure of 500~500,000 Pa.

Preferably, the nozzle 20 is made of graphite, ceramic or inert metals, as well as other materials that are resistant to high temperature, wear and can be processed.

Preferably, said nozzle outlet is of a slit shape or multi-hole. Wherein, the slit shape nozzle outlet is linear of curvilinear, and the multi-hole outlet is rectangular, round or trapezoidal in shape.

Preferably, said pressure stabilizing plate 19 has a multi-hole structure, the holes in said pressure stabilizing plate are rectangular, circle or triangular in shape. Or, the hole shape can be arbitrary polygonal or circle, the present application does not specifically limit the shape of the holes. And those holes run in linear or curvilinear direction or have a multilayer structure.

Preferably, said molten metal 14 contains metals such as zinc, magnesium, aluminum, tin, nickel, copper, iron, etc., in addition to low melting point (below 2000°C) oxides of these metals.

Preferably, the steel plate 100 is cleaned by plasma or other devices before vacuum coating, and the preheating temperature reaches 80~300°C.

The specific steps for using the vacuum coating device of the present invention are as follows.

1) Solid metal is melted into molten metal 14 in the crucible 13 by the induction heater 15, and then the molten metal 14 begins to vaporize at a high overheat temperature and low pressure, gradually forming the metal steam 22.

2) In the beginning phase, the pressure regulating valve 18 arranged in the steam pipe 16 connected to the crucible 13 is closed.

3) As the molten metal 14 continuously vaporizes the steam pressure in the inner chamber of the crucible 13 increases. When the pressure of the inner cavity of the crucible 13 reaches a certain value, for example, 5,000~500,000 Pa, the pressure regulating valve 18 is opened to allow the steam to flow out at a constant pressure.

4) Increasing the power of induction heater 15 so as to compensate for the reduced pressure due to the opening of the pressure regulating valve 18, and adjusting the power of induction heater 15 to make sure that the pressure of the inner cavity of the crucible 13 is maintained in a certain range.

5) After the pressure regulating valve 18 opens, the metal steam 22 flows along the steam pipe 16. When the metal steam 22 enters into the flow distribution box 17, the pressure of the high-velocity stream formed by the metal steam is reduced due to the restriction of the pressure stabilizing plate 19. And the distribution of holes in the pressure stabilizing plate distributes the high-velocity stream, so that the metal steam flows uniformly along the holes in the pressure stabilizing plate 19 and subsequently flows uniformly from the nozzle 20 at the top of the flow distribution box 17.

6) Due to the arrangement of the deflector 21 at the top of the nozzle 20, the deflected flow after the steam is emitted from the nozzle 20 is reduced during the coating process, so that the metal steam 22 can flow out from both sides of the steel plate 100 after passing through the steel plate 100, thus improving the yield of the coating.

7) Due to the narrow outlet of the nozzle, the metal steam 22 flows out at a large speed. At this time, a moving steel plate 100 is arranged above the nozzle outlet, the temperature of the metal steam 22 is high, when the metal steam reaches the low-temperature steel plate 100, it solidifies rapidly, forming a metal coating 24.

Embodiment

The steel plate 100 is galvanized, and the width of the steel plate 100 is 1,000 mm. After cleaning and drying, the steel plate 100 is heated to 120°C. Zinc on steel plate surface is vaporized by the induction heater 15, and then adjust the power of the induction heater to raise the pressure in the crucible 13 to 20,000 Pa, at which point the pressure regulating valve 18 is closed. When the pressure in the crucible 13 reaches 20,000 Pa, the pressure regulating valve 18 is opened, and then the metal steam 22 enters into the flow distribution box 17 through the steam pipe 16. The pressure stabilizing plate in the flow distribution box 17 has a multi-hole structure or adopts a pressure stabilizing plate made of multi-hole media. The working pressure in the flow distribution box 17 is 5,000 Pa. The nozzle 20 is made of graphite, and the nozzle outlet is of a linear slit.

The deflector 21 is rectangular, and the relevant parameters are as follows:

Da=120mm;
Db=70mm;
Dc=50mm;
Dd=90°.

The yield of coating reaches 95%.

**Claims**

1. A vacuum coating device for coating a steel plate (100), comprising:

a crucible (13),
an induction heater (15) provided on the periphery of the crucible (13),
a flow distribution box (17) connected to the top of said crucible (13) via a steam pipe (16), wherein
said steam pipe (16) is provided with a pressure regulating valve (18), said flow distribution box (17) is provided inside with a horizontal pressure stabilizing plate (19), said flow distribution box (17) is connected on the top with a nozzle (20), a deflector (21) being arranged above said nozzle (20) along the emitting direction of the steam, and wherein
a distance Da from nozzle outlet to steel plate (100) is 10-200 mm,
a height Db of said deflector (21) is 10-199 mm;
a distance Dc from top of said deflector (21) to steel plate (100) is 1~190 mm;
an angle Dd between said deflector (21) and said nozzle outlet is 60°~135°;
wherein Da, Db, Dc, and Dd satisfy the following relationships:

$$Da=Db+Dc;$$

when Da=100~200mm and Db=(1/5~1/2)Da, Dd=60°~90°;
when Da=100-200mm and Db=(1/2~2/3)Da, Dd=70°~110°;
when Da=100-200mm and Db=(2/3~4/5)Da, Dd=80°~135°;
when Da=10~100mm and Db=(1/5~1/2)Da, Dd=60°~100°;
when Da=10~100mm and Db=(1/2~2/3)Da, Dd=70°~120°;
when Da=10~100mm and Db=(2/3~4/5)Da, Dd=80°~135°.

2. The vacuum coating device for coating a steel plate (100) of claim 1, wherein said pressure stabilizing plate (19) is of multi-hole structure, the holes being rectangular, circle or triangular in shape, and running in linear or curvilinear direction or having a multilayer structure.

3. The vacuum coating device for coating a steel plate (100) of claim 1, wherein said nozzle outlet is of a slit shape or multi-hole.

4. The vacuum coating device for coating a steel plate (100) of claim 3, wherein said nozzle outlet is of a linear slit or a curvilinear slit.

5. The vacuum coating device for coating a steel plate (100) of claim 3, wherein the multi-hole nozzle outlet is rectangular, round or trapezoidal in shape.

6. The vacuum coating device for coating a steel plate (100) of claim 3, wherein said nozzle (20) is made of graphite, ceramic or metal.

7. The vacuum coating device for coating a steel plate (100) of claim 1, further comprising a vacuum chamber (23), said flow distribution box (17) and said steel plate (100) being placed in said vacuum chamber (23).

**Patentansprüche**

1. Eine Vakuumbeschichtungsvorrichtung zum Beschichten einer Stahlplatte (100), umfassend:

einen Tiegel (13),
eine Induktionsheizung (15), die auf dem Umfang des Tiegels (13) bereitgestellt ist,
einen Strömungsverteilerkasten (17), der über eine Dampfleitung (16) mit der Oberseite des Tiegels (13) verbunden ist, wobei

die Dampfleitung (16) mit einem Druckregelventil (18) versehen ist, der Strömungsverteilerkasten (17) im Inneren mit einer horizontalen Druckstabilisierungsplatte (19) versehen ist, der Strömungsverteilerkasten (17) oben mit einer Düse (20) verbunden ist,

einen Deflektor (21), der oberhalb der Düse (20) entlang der Austrittsrichtung des Dampfes angeordnet ist, und wobei

der Abstand Da vom Düsenausgang zur Stahlplatte (100) 10-200 mm beträgt,

eine Höhe Db des Deflektors (21) 10-199 mm beträgt;

ein Abstand Dc von der Oberseite des Deflektors (21) zur Stahlplatte (100) 1-190 mm beträgt;

ein Winkel Dd zwischen dem Deflektor (21) und dem Düsenausgang 60°~135° beträgt;

wobei Da, Db, Dc und Dd die folgenden Beziehungen erfüllen:

$$Da = Db + Dc;$$

wenn Da=100-200 mm und Db=(1/5~1/2)Da, Dd=60°~90°;

wenn Da=100-200 mm und Db=(1/2~2/3)Da, Dd=70°~110°;

wenn Da=100-200 mm und Db=(2/3~4/5)Da, Dd=80°~135°;

wenn Da=10-100 mm und Db=(1/5~1/2)Da, Dd=60°~100°;

wenn Da=10-100 mm und Db=(1/2~2/3)Da, Dd=70°~120°;

wenn Da=10-100 mm und Db=(2/3~4/5)Da, Dd=80°~135°.

2. Die Vakuumbeschichtungsvorrichtung zum Beschichten einer Stahlplatte (100) nach Anspruch 1, wobei die Druckstabilisierungsplatte (19) eine Mehrlochstruktur aufweist, wobei die Löcher rechteckig, kreisförmig oder dreieckig sind und in linearer oder gekrümmter Richtung verlaufen oder eine Mehrschichtstruktur haben.

3. Die Vakuumbeschichtungsvorrichtung zum Beschichten einer Stahlplatte (100) nach Anspruch 1, wobei der Düsenauslass schlitzförmig oder mehrlochig ist.

4. Die Vakuumbeschichtungsvorrichtung zum Beschichten einer Stahlplatte (100) nach Anspruch 3, wobei der Düsenauslass ein linearer Schlitz oder ein gekrümmter Schlitz ist.

5. Die Vakuumbeschichtungsvorrichtung zum Beschichten einer Stahlplatte (100) nach Anspruch 3, wobei der Mehrlochdüsenauslass eine rechteckige, runde oder trapezförmige Form hat.

6. Die Vakuumbeschichtungsvorrichtung zum Beschichten einer Stahlplatte (100) nach Anspruch 3, wobei die Düse (20) aus Graphit, Keramik oder Metall besteht.

7. Die Vakuumbeschichtungsvorrichtung zum Beschichten einer Stahlplatte (100) nach Anspruch 1, die ferner eine Vakuumkammer (23) umfasst, wobei der Strömungsverteilerkasten (17) und die Stahlplatte (100) in der Vakuumkammer (23) angeordnet sind.

**Revendications**

1. Dispositif de revêtement sous vide pour revêtir une plaque d'acier (100), comprenant :

un creuset (13),
un élément de chauffage par induction (15) disposé sur la périphérie du creuset (13),
un boîtier de distribution d'écoulement (17) relié à la partie supérieure dudit creuset (13) via un tuyau de vapeur (16), dans lequel
ledit tuyau de vapeur (16) est doté d'une vanne de régulation de pression (18), ledit boîtier de distribution d'écoulement (17) est doté à l'intérieur d'une plaque de stabilisation de pression horizontale (19), ledit boîtier de distribution d'écoulement (17) est relié sur la partie supérieure à une buse (20),
un déflecteur (21) étant agencé au-dessus de ladite buse (20) le long de la direction d'émission de la vapeur, et dans lequel
une distance Da d'une sortie de buse à la plaque d'acier (100) est de 10-200 mm,
une hauteur Db dudit déflecteur (21) est de 10-199 mm ;
une distance Dc de la partie supérieure dudit déflecteur (21) à la plaque d'acier (100) est de 1~190 mm ;
un angle Dd entre ledit déflecteur (21) et ladite sortie de buse est de 60°~135° ;
dans lequel Da, Db, Dc et Dd satisfont aux relations suivantes :

$$Da = Db + Dc;$$

lorsque Da = 100-200 mm et Db = (1/5-1/2)Da, Dd = 60°~90° ;
lorsque Da = 100-200 mm et Db = (1/2-2/3)Da, Dd = 70°~110° ;
lorsque Da = 100-200 mm et Db = (2/3-4/5)Da, Dd = 80°~135° ;
lorsque Da = 10-100 mm et Db = (1/5-1/2)Da, Dd = 60°~100° ;

lorsque Da = 10-100 mm et Db = (1/2-2/3)Da, Dd = 70°~120° ;
lorsque Da = 10~100 mm et Db = (2/3-4/5)Da, Dd = 80°~135°.

2. Dispositif de revêtement sous vide pour revêtir une plaque d'acier (100) selon la revendication 1, dans lequel ladite plaque de stabilisation de pression (19) présente une structure à trous multiples, les trous étant de forme rectangulaire, circulaire ou triangulaire, et s'étendant dans une direction linéaire ou curviligne ou ayant une structure multicouche.

3. Dispositif de revêtement sous vide pour revêtir une plaque d'acier (100) selon la revendication 1, dans lequel ladite sortie de buse présente une forme de fente ou des trous multiples.

4. Dispositif de revêtement sous vide pour revêtir une plaque d'acier (100) selon la revendication 3, dans lequel ladite sortie de buse présente une fente linéaire ou une fente curviligne.

5. Dispositif de revêtement sous vide pour revêtir une plaque d'acier (100) selon la revendication 3, dans lequel la sortie de buse à trous multiples est de forme rectangulaire, ronde ou trapézoïdale.

6. Dispositif de revêtement sous vide pour revêtir une plaque d'acier (100) selon la revendication 3, dans lequel ladite buse (20) est en graphite, céramique ou métal.

7. Dispositif de revêtement sous vide pour revêtir une plaque d'acier (100) selon la revendication 1, comprenant en outre une chambre à vide (23), ledit boîtier de distribution d'écoulement (17) et ladite plaque d'acier (100) étant placés dans ladite chambre à vide (23).

FIG. 1

FIG. 2

FIG. 3

FIG. 4

FIG. 5

FIG. 6

FIG. 7

FIG. 8

FIG. 9

FIG. 10

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- BE 1009321 A6
- BE 1009317A61
- US 4552092 A
- WO 2018020311 A1
- CN 103249860 A
- CN 101175866 A
- WO 2014168352 A1
- JP S59177370 A